(19) Europäisches Patentamt
European Patent Office
Office européen des brevets

(11) EP 2 710 344 B1

(12) **EUROPÄISCHE PATENTSCHRIFT**

(45) Veröffentlichungstag und Bekanntmachung des Hinweises auf die Patenterteilung:
**02.11.2016 Patentblatt 2016/44**

(21) Anmeldenummer: **12715633.9**

(22) Anmeldetag: **19.03.2012**

(51) Int Cl.:
*G01L 1/16* (2006.01)      *H01L 41/113* (2006.01)

(86) Internationale Anmeldenummer:
**PCT/EP2012/054833**

(87) Internationale Veröffentlichungsnummer:
**WO 2012/156126 (22.11.2012 Gazette 2012/47)**

(54) **SENSORELEMENT MIT PIEZOELEKTRISCHEM WANDLER**

SENSOR DEVICE HAVING A PIEZOELECTRIC TRANSDUCER

DISPOSITIF CAPTEUR COMPORTANT UN CONVERTISSEUR PIÉZOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2011 DE 102011076105**

(43) Veröffentlichungstag der Anmeldung:
**26.03.2014 Patentblatt 2014/13**

(73) Patentinhaber: **Robert Bosch GmbH
70442 Stuttgart (DE)**

(72) Erfinder:
- **FRANKE, Axel
  71254 Ditzingen (DE)**
- **BUHMANN, Alexander
  72760 Reutlingen (DE)**
- **HENRICI, Fabian
  70195 Stuttgart (DE)**

(56) Entgegenhaltungen:
**EP-A1- 1 553 697      US-A- 5 760 530
US-A1- 2012 092 181**

**Beschreibung**

Stand der Technik

Die Erfindung betrifft ein Sensorelement mit mindestens einem piezoelektrischen Wandler.

Der piezoelektrische Effekt ist an sich bekannt und wird technisch ausgenutzt, um eine anliegende Kraft zu messen. Die Kraft führt hierbei zu einer elastischen Verformung eines Balkens oder einer Membran und dadurch zu einer Änderung der elektrischen Polarisation im Material. Aufgrund dessen kommt es zu einer Ladungstrennung, welche wiederum als Spannung detektierbar ist. Der piezoelektrische Effekt tritt nur in bestimmten Materialien auf. Hierzu zählen zum Beispiel Quarz, Blei-Zirkonat-Titanat (PZT), Aluminiumnitrid (AlN) sowie bestimmte Keramiken.

Die Ladungstrennung in einem piezoelektrischen Wandler wird jedoch je nach Material und umgebender Schaltung mehr oder weniger lange Bestand haben, das heißt eine Änderung der anliegenden Kraft von einem ersten konstanten auf ein zweites kontantes Niveau (Sprung) wird ein Wandler nach mehr oder weniger langer Zeit "vergessen". Dies bedeutet, dass ein direkt genutzter piezoelektrischer Wandler nicht zur Messung von DC ("Direct Current", d.h. Gleichstrom)-Signalen in der Lage ist. Ein piezoelektrischer Wandler als solcher ist somit prinzipbedingt nicht besonders geeignet dafür, zeitlich konstante Kräfte in Messsignale (Spannungen) umzuwandeln. Zu diesem Zweck ist im Stand der Technik eine flächenintensive aktive Schaltung erforderlich (Ladungsverstärker), die sich üblicherweise aus Platzgründen nicht direkt am Ort des piezoelektrischen Wandlers unterbringen lässt.

In Sensoren, wie sie beispielsweise in der Automobilindustrie Verwendung finden, werden piezoelektrische Wandler häufig eingesetzt, um den bei einer elastischen Verformung, z.B. den bei einer Sensormembran auftretenden piezoelektrischen Effekt zu messen. Solche piezoelektrischen Wandler werden etwa in Kraft-, Druck- oder Beschleunigungssensoren eingesetzt. Eine mechanische Verformung in derartigen Kraft-, Druck- oder Beschleunigungssensoren führt zu einer piezoelektrischen Ladung, die mit einem Ladungsverstärker in eine elektrische Spannung mit niedriger Impedanz umgewandelt werden kann. Die Ladung kann auch verwendet werden, um einen Kondensator aufzuladen und dessen Spannung mit einem möglichst hochohmigen Voltmeter zu messen. Allerdings können hierbei mangelhafte Isolationswiderstände beispielsweise durch Feuchtigkeit das Ergebnis verfälschen und die Registrierung relativ langsamer Verformungen erschweren.

DE 2 109 388 A beschreibt einen piezoelektrischen Wandler, der an einen Verstärker beziehungsweise Impedanzwandler mit einem ersten Transistor und einem zweiten Transistor angeschlossen ist. Der piezoelektrische Wandler ist mit den Transistoren in einem einzigen Wandlergehäuse untergebracht. Zudem müssen die Transistoren über ein Kabel mit Spannung zum Beispiel aus einer Batterie betrieben werden. Zur Verstärkung beziehungsweise Wandlung des Signals des piezoelektrischen Wandlers muss somit ein hoher schaltungstechnischer Aufwand betrieben werden, der unter anderem dazu führt, dass die gesamte Anordnung, beispielsweise für einen Verbau in einem Fahrzeug, vergleichsweise groß und unhandlich ist.

Aus der EP 1 553 697 A1 ist ein piezoelektrischer Wandler zur Messung von niederfrequenten Signalen bekannt, der zur Signalverstärkung an eine nichtlineare Impedanzanpassungsschaltung gekoppelt ist. In einem Ausführungsbeispiel umfasst diese Impedanzanpassungsschaltung einen Memristor als nichtlineare Komponente.

Offenbarung der Erfindung

Erfindungsgemäß wird ein Sensorelement mit mindestens einem piezoelektrischen Wandler vorgeschlagen, wobei der piezoelektrische Wandler mit mindestens einem Memristor , der Teil einer Halbbrücke ist, gekoppelt ist.

Ein Memristor (Kofferwort: Memory und Resistor) im Sinne der vorliegenden Erfindung ist ein passives Bauelement, dessen elektrischer Widerstand nicht konstant ist, sondern von seiner Vergangenheit abhängt. Der Memristor wird neben dem Widerstand, dem Kondensator und der Spule üblicherweise als viertes fundamentales passives Bauelement beschrieben. Das grundliegende Verhalten von Memristoren wurde bereits ausführlich theoretisch untersucht (Strukov et al., The missing memristor found, Nature 453 (2008), Seite 80ff). Die Verwendung von Memristoren ist beispielsweise in US 2010/019656 A1 im Zusammenhang mit einem magnetischen Speicherelement beschrieben. DE 10 2009 026 189 A1 erwähnt den Einsatz von Memristoren als Alternative zu RAM-Bauteilen (Random Access Memory) für Speicherelemente.

Bei einem Memristor ist der aktuelle Widerstand des Bauelements davon abhängig, wie viele Ladungen, $q(t)$, in welche Richtung geflossen sind. Insbesondere hängt der Widerstand des Memristors, der auch als Memristanz, $M(t)$, bezeichnet wird, vom Integral des in der Vergangenheit durch ihn geflossenen Stroms, $i(t)$, ab. Die über dem Memristor abfallende Spannung, $u(t)$, ist somit über die Memristanz, $M(t)$, und den Strom, $i(t)$, zu $u(t)=M(q(t)) I(t)$ gegeben.

In einer Realisierung des Memristors kann dieser mindestens zwei Bereiche unterschiedlicher Leitfähigkeit umfassen. Dabei weisen die mindestens zwei Bereiche des Memristors eine bestimmte Größe auf. Fließt ein Strom durch das Bauteil, so kann sich die Größe dieser Bereiche ändern. Beispielsweise können die Bereiche als Schichten aus jeweils einem Isolator und einem metallisch leitenden Material ausgebildet sein. Typische Materialien, die in diesem Zusammenhang zum Einsatz kommen umfassen $TiO_2$ und dotiertes $TiO_2$, wie zum Bei-

spiel $TiO_{2-x}$ mit x=0.05. In diesem konkreten Beispiel verschiebt sich die Grenze zwischen den beiden Bereichen, wenn Sauerstoffionen beziehungsweise die als Dotierstoff fungierenden Leerstellen im elektrischen Feld transportiert werden. Aufgrund der Bauweise kann der Memristor verschiedene Polaritäten aufweisen, wobei die Einbaurichtung relevant ist.

Bei der erfindungsgemäßen Ausbildung des Sensorelements ist der Memristor Teil einer Halbbrücke. Die Halbbrücke umfasst üblicherweise eine Serienschaltung von zwei Bauelementen sowie einen Brückenzweig, der zwischen den beiden Bauelementen quer verläuft. Vorzugsweise beinhaltet die Halbbrücke zwei passive Bauelemente, wobei mindestens eines dieser Bauelemente ein Memristor sein kann. Die Halbbrücke kann zwei Memristoren entgegengesetzter Polarität enthalten.

Das Sensorelement kann ferner ausgebildet sein, um in einem Auslesebetrieb oder einem Messbetrieb betrieben zu werden. Der Wechsel zwischen dem Auslesebetrieb und dem Messbetrieb kann mithilfe von Schaltern erfolgen. Dabei kann der Schalter im Messbetrieb so geschaltet werden, dass der Memristor des Sensorelementes mit dem piezoelektrischen Wandler gekoppelt ist. Im Auslesebetrieb kann der Schalter umgelegt werden, so dass der Memristor vom piezoelektrischen Wandler entkoppelt ist und mit einer Ausleseelektronik in Kontakt kommt. Die Ausleseelektronik kann eine Spannungsquelle, vorzugweise eine Wechselspannungsquelle und ein Spannungsmessgerät wie beispielsweise ein Voltmeter umfassen.

Der Wandler und der Memristor können aus CMOS-kompatiblen Materialien gefertigt sein. Geeignete Materialien sind insbesondere solche, die in der Halbleiterfertigung zum Einsatz kommen, wie zum Beispiel AlN für den piezoelektrischen Wandler und $TiO_2$ für den Memristor.

Weiterhin wird erfindungsgemäß ein Verfahren zum Betreiben des vorstehend beschriebenen Sensorelements vorgeschlagen, wobei ein Auslesen des Sensorelements mittels einer Wechselspannung erfolgt.

Zusätzlich wird erfindungsgemäß ein Sensor mit einer Anordnung von einer Mehrzahl von Pixeln vorgeschlagen, wobei mindestens einer der Pixel ein Sensorelement wie vorstehend beschrieben umfasst.

In einer Ausführungsform des erfindungsgemäßen Sensors umfasst die Anordnung eine Matrixanordnung einer Mehrzahl von Sensorelementen.

In einer weiteren Ausführungsform des erfindungsgemäßen Sensors ist dieser zur niederohmigen Anbindung an eine Ausleseelektronik ausgebildet.

Auch ein Verfahren zum Betreiben eines Sensors wird erfindungsgemäß vorgeschlagen, wobei ein Auslesen des Sensors zeilen- und/oder spaltenweise erfolgt.

Bei einer Implementierung des erfindungsgemäßen Verfahrens zum Betreiben des Sensors erfolgt das Auslesen der Pixel zeitversetzt.

Erfindungsgemäß wird die Verwendung des Sensorelements wie vorstehend beschrieben in einem Kraftsensor, einem Drucksensor, einem Drehbeschleunigungssensor oder einem Stresssensor bzw. einem mechanischen Spannungssensor vorgeschlagen.

Vorteile der Erfindung

Die erfindungsgemäß vorgeschlagene Kombination aus piezoelektrischem Wandler mit Memristor erlaubt es, das entstandene transiente Signal vor Ort zu erfassen. Daraus ergibt sich ein geringerer Flächenbedarf, im Vergleich zu einer aktiven Schaltung. Das entstandene Signal verändert die Memristanz, M(t), des Memristors und kann jederzeit zuverlässig ausgelesen werden, wobei das Auslesen niederohmig und somit störungsunempfindlich ist.

Ferner ermöglicht der kleine Flächenbedarf, die erfindungsgemäß vorgeschlagene Kombination aus piezoelektrischem Wandler mit Memristor als Pixel in einer Anordnung von einer Mehrzahl von Pixeln vorzusehen und so eine hohe Auflösung zu erreichen. Zudem lassen sich einzelne Pixel zeitversetzt auslesen. Weiterhin werden durch die niederohmige Anbindung der Ausleseelektronik robuste Signale übertragen, so dass elektromagnetische Störungen die Messung nicht beeinflussen.

Kurze Beschreibung der Zeichnungen

Weitere Aspekte und Vorteile der Erfindung werden nunmehr anhand der beigefügten Figuren eingehender beschrieben. Hierbei zeigt:

Figur 1      ein Ersatzschaltbild eines piezoelektrischen Wandlers, wie aus dem Stand der Technik bekannt,

Figur 2      eine Sprungantwort des piezoelektrischen Wandlers gemäß Figur 1,

Figur 3      ein Sensorelement mit piezoelektrischem Wandler und parallel geschaltetem Memristor,

Figur 4      eine Sprungantwort des Sensorelements gemäß Figur 3,

Figur 5      das Sensorelement im Messbetrieb,

Figur 6      das Sensorelement im Auslesebetrieb,

Figur 7      einen differenziellen Aufbau eines erfindungsgemäßen Sensorelements im Auslesebetrieb,

Figur 8      ein Sensor mit in einer Matrix angeordneten Sensorelementen, wobei für die Pixel eine spalten- und zeilenweise Auslesung erfolgt.

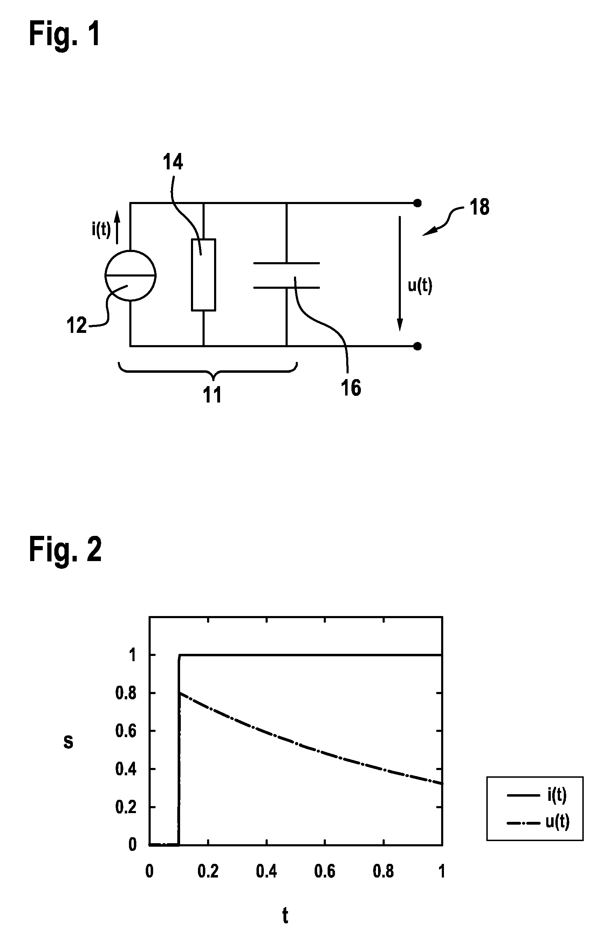

Figur 1 zeigt ein Ersatzschaltbild eines piezoelektrischen Wandlers 11. Das Ersatzschaltbild des piezoelektrischen Wandlers 11 beinhaltet eine Stromquelle 12, die den piezoelektrischen Effekt emuliert. Die Stromstärke, i(t), weißt dabei einen Verlauf auf, der von der piezoelektrischen Empfindlichkeit, k, und der zu wandelnden Kraft, F, abhängt,

$$i(t) = k \; \delta F(t)/\delta t.$$

Außerdem sind ein Innenwiderstand 14 und eine Kapazität 16 zur Stromquelle 12 parallel geschaltet. Am Ausgang 18 ergibt sich die Ausgangsspannung des piezoelektrischen Wandlers 11, u (t).
Figur 2 zeigt die Sprungantwort des piezoelektrischen Wandlers 11 gemäß Figur 1, das heißt die resultierende Ausgangsspannung, u(t), bei einer stufenförmigen Eingangsstromstärke, i(t). Die Sprungantwort oder das sprungartige Ändern der Eingangsstromstärke, i(t), erfolgt beispielsweise durch Anlegen eines Kraftsprunges an den Wandler 11. Figur 2 stellt das Verhalten des piezoelektrischen Wandlers 11 anhand des Signalstärkenverlaufs, s, der Eingangsstromstärke, i(t), und der Ausgangsspannung, u(t), in Abhängigkeit von der Zeit, t, dar. Die kurzzeitig hohe Stromstärke, i(t), lädt die Kapazität auf und führt so zu einem Abfall der Ausgangsspannung, u(t). Da ein realer piezoelektrischer Wandler 11 immer einen endlichen Innenwiderstand 14 aufweist, entlädt sich die Kapazität 16 über den Widerstand 14. Das resultierende Spannungssignal, u(t), sinkt daher mit zunehmender Zeit ab.

Ausführungsformen

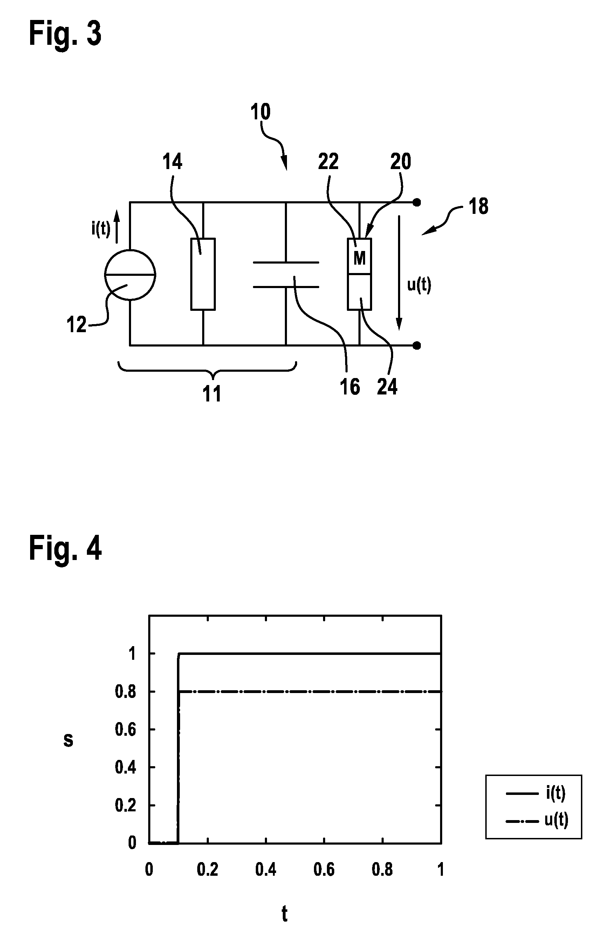

Figur 3 zeigt ein Sensorelement 10, wobei der piezoelektrische Wandler 11 im Ersatzschaltbild gemäß Figur 1 dargestellt ist. Das Sensorelement 10 umfasst den piezoelektrische Wandler 11, der mit einem Memristor 20 gekoppelt ist. Der Memristor 20 ist dem piezoelektrischen Wandler 11 parallel geschaltet. Ferner umfasst der Memristor 20 zwei Bereiche 22, 24, wobei ein erster Bereich 22 beispielsweise $TiO_2$ beinhaltet und ein zweiter Bereich 24 beispielsweise dotiertes $TiO_{2-x}$ enthält. Ähnlich wie in Figur 1 bezeichnen i(t) die Eingangsstromstärke des piezoelektrischen Wandlers 11 und u(t) die Ausgangsspannung des Sensorelements 10.
Durch die Kopplung des Memristors 20 mit dem piezoelektrischen Wandler 11 ergeben sich gegenüber dem Stand der Technik neue Möglichkeiten. Denn der Memristor selbst hat einen relativ zum Innenwiderstand 14 des piezoelektrischen Wandlers 11 um mehrere Größenordnungen geringeren Widerstandswert. Dies verringert die Zeitkonstante des Ausgangsspannungssignals, u(t). Der Großteil der auf dem Kondensator 16 zwischengespeicherten Ladungen fließt in der Schaltung gemäß Figur 3 über den Memristor 20 ab und verändert dabei dessen Widerstandswert, M(t) (Memresistanz). Die Änderung des Widerstandswertes beruht dabei auf einer Größenänderung der Memristorbereiche 22, 24. Die Bereiche 22, 24 weisen typischerweise eine unterschiedliche Leitfähigkeit auf und die Grenze zwischen den Bereichen 22, 24 verschiebt sich, wenn Sauerstoffionen beziehungsweise die als Dotierstoff fungierenden Leerstellen im elektrischen Feld transportiert werden. Auf diese Weise enthält der Memristor 20 die Information über das aktuell anliegende Kraftsignal und speichert dieses.
Figur 4 zeigt im Vergleich zu der Sprungantwort des piezoelektrischen Wandlers 11 gemäß Figur 2 die Sprungantwort des vorgeschlagenen Sensorelements 10 mit parallel geschaltetem Memristor 20. Ähnlich wie Figur 2 stellt Figur 4 das Verhalten des Sensorelements 10 anhand des Verlaufs der Eingangsstromstärke, i(t), und der Ausgangsspannung, u(t), in Abhängigkeit von der Zeit dar. Im Unterschied zu Figur 2 folgt die Ausgangsspannung, u(t), der kurzzeitig hohen Stromstärke, i (t). Aufgrund der stark verringerten Zeitkonstante in Sensorelement 10 mit parallel geschaltetem Memristor 20, folgt die Ausgangsspannung, u(t), der Stromstärke, i(t). Dabei fließt Ladung über den Memristor 20 und verändert dessen Widerstandswert, M(t).

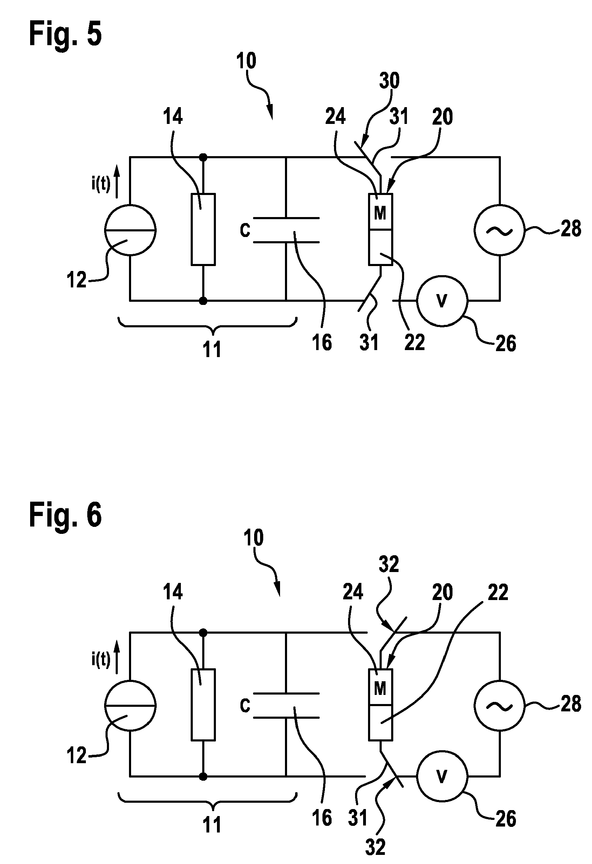

Die Figuren 5 und 6 zeigen das Ersatzschaltbild des piezoelektrischen Wandlers 11 umfassend eine Stromquelle 12, einen Innenwiderstand 14 und einen Kondensator 16, wobei ein Memristor 20 parallel geschaltet ist. In Figur 5 ist eine Realisierung des Messbetriebes 30 angedeutet. In der Anordnung gemäß Figur 5 speichert der Memristor 20 durch seine Memresistanz, wie viel Ladung über den Memristor 20 geflossen ist. Dazu befindet sich der Memristor 20 in Verbindung mit dem piezoelektrischen Wandler 11. Während des Messbetriebes 30 fließen Ladungen über den Memristor 20, wodurch sich die Bereiche 22 und 24 in ihrer Größe ändern und somit die Memristanz des Memristors 20 ändern.
Figur 6 zeigt die Schaltung gemäß Figur 5, wobei sich der Memristor 20 im Auslesebetrieb 32 befindet. Zum Auslesen des Memristors wird ein Voltmeter 26 mit dem Memristor 20 in Serie geschaltet und eine Wechselspannungsquelle 28 angeschlossen. Auf diese Weise kann mittels der Anzeige des Voltmeters 26 die Memritanz des Memristors 20 bestimmt werden. Beim Auslesen des Memristors 20 ist die Verwendung einer Wechselspannung besonders vorteilhaft, da diese die Memristivität im zeitlichen Mittel unverändert lässt.
Wie in den Figuren 5 und 6 schematisch angedeutet, wird zwischen dem Messbetrieb 30 und dem Auslesebetrieb 32 des Memristors 20 mit Hilfe eines Schalters 31 hin- und her geschaltet. Auf diese Weise kann die Memristanz des Memristors in regelmäßigen Abständen ausgelesen werden.

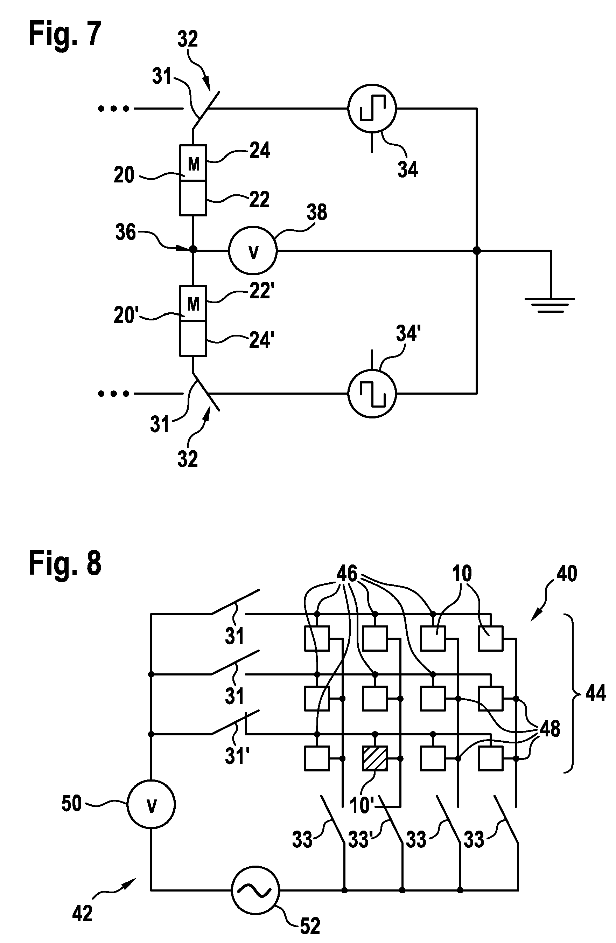

Figur 7 zeigt eine Ausführungsform des erfindungsgemäßen Sensorelements 10, in dem anstatt eines Memristors 20 zwei Memristoren 20, 20' mit entgegengesetzter Polarität in Serie geschaltet sind. In diesem Zusammenhang bedeutet entgegengesetzte Polarität, dass die Memristoren 20, 20' so verschaltet sind, dass die Bereiche 22, 22' in Serie geschaltet sind. Auf diese Weise ist die Polarität der Memristoren 20, 20', welche jeweils von dem Bereich 22, 22' zu dem Bereich 24, 24' weist, entgegengesetzt gepolt. Figur 7 zeigt das erfindungsgemäße Sensorelement 10 im Auslesebetrieb 32, wobei sich die Schalter 31 in der Ausleseposition befinden. Im Brückenzweig 36 sind die Memristoren 20, 20' mit einem Voltmeter 38 verbunden. Zusätzlich sind die Memristoren 20, 20' jeweils mit einem Signalgenerator 34, 34' in Serie geschaltet und mit einer von Signalgeneratoren 34, 34' generierten Sprungfunktion beaufschlagt.

Auf diese Weise wird eine Halbbrücke zur Verfügung gestellt, mit der eine differenzielle Messung der Memristanz der beiden Memristoren 20, 20' durchgeführt werden kann, da sich je nach Memristanz die Spannung und die Stromstärke im Brückenzweig 36 in der Höhe und in der Polarität verändern. Die differenzielle Auslesung mittels Halbbrücke hat darüber hinaus den Vorteil, dass Drift beziehungsweise Netzstörungen ausgeglichen werden und die Messung der Memristanz der beiden Memristoren 20, 20' somit insgesamt stabiler stattfinden kann.

In Figur 8 ist ein erfindungsgemäßer Sensor 40 dargestellt, der einzelne Sensorelemente 10, 10' als Pixel enthält. Die Sensorelemente 10, 10' umfassen jeweils eine Kombination aus piezoelektrischem Wandler 11 und Memristor 20. Der Sensor 40 ist weiterhin so ausgebildet, dass der Sensor eine niederohmige Anbindung an eine Ausleseelektronik 42 ermöglicht. Dazu sind die Sensorelemente 10, 10' in einer Matrixanordnung 44 so miteinander verschaltet, dass jeweils ein Anschluss 46 ein Sensorelement 10, 10' mit mindestens einem weiteren Sensorelement 10, 10' der Zeile 46 in Serie schaltet und/oder jeweils ein weiterer Anschluss 48 ein Sensorelement 10, 10' mit mindestens einem weiteren Sensorelement 10, 10' der Spalte 46 in Serie schaltet.

Die Ausleseelektronik 42 umfasst eine Spannungsquelle 52, die eine Wechselspannung bereitstellt, und ein Voltmeter, um den Spannungsabfall über mindestens ein Sensorelement 10, 10' zu messen. Das Auslesen der Sensorelemente 10, 10' erfolgt über die Schalter 31, 31', 33, 33' der Auswertelektronik. Auf diese Weise werden die einzelnen Sensorelemente 10, 10' mit der Ausleseelektronik 42 zeilen- und spaltenweise ausgelesen. In Figur 8 sind exemplarische die Schalter 31' und 33' geschlossen, wobei der Schalter 31' die Zeile und der Schalter 33' die Spalte selektiert. In der in Figur 8 dargestellten Position der Schalter 31' und 33' wird das Sensorelement 10' ausgelesen.

In anderen Ausführungsformen des Sensors 40 können unterschiedliche Zahlen von Sensorelementen 10, 10' in beliebig vielen Zeilen und Spalten vorgesehen werden. Es könnten beispielsweise eine Anzahl von Sensorelementen in der gleichen Anzahl von Spalten und nur einer Zeile angeordnet sein. Eine solche Matrixanordnung erlaubt es einzelne Pixel, die jeweils ein Sensorelement 10, 10' umfassen, spalten- und zeilenweise auszulesen, um mit dem Sensor beispielsweise Druckverteilungen zu detektieren. Die kleine Baugröße der einzelnen Sensorelemente ermöglicht dabei eine hohe Auflösung. Zudem lassen sich einzelne Pixel zeitversetzt auslesen. Durch die niederohmige Anbindung der Ausleseelektronik werden robuste Signale übertragen, so dass elektromagnetische Störungen, die beispielsweise durch die Zuleitung empfangen werden, die Messung nicht beeinflussen.

Die Erfindung ist nicht auf die hier beschriebenen Ausführungsbeispiele und die darin hervorgehobenen Aspekte beschränkt; vielmehr sind innerhalb des durch die anhängenden Ansprüche angegebenen Bereichs eine Vielzahl von Abwandlungen möglich, die im Rahmen fachmännischen Handelns liegen.

**Patentansprüche**

1. Sensorelement (10) mit mindestens einem piezoelektrischen Wandler (11), wobei der piezoelektrische Wandler (11) mit mindestens einem Memristor (20) gekoppelt ist, **dadurch gekennzeichnet, dass** der Memristor (20) Teil einer Halbbrücke ist.

2. Sensorelement (10) nach Anspruch 1, wobei der piezoelektrische Wandler (11) mit der Halbbrücke parallel geschaltet ist.

3. Sensorelement (10) nach Anspruch 1, wobei die Halbbrücke zwei Memristoren (20) entgegengesetzter Polarität umfasst.

4. Sensorelement (10) nach einem der vorhergehenden Ansprüche, wobei das Sensorelement (10) ausgebildet ist, um in einem Auslesebetrieb (30) oder einem Messbetrieb (32) betrieben zu werden.

5. Sensorelement (10) nach einem der vorhergehenden Ansprüche, wobei der Wandler (11) und der Memristor (20) aus CMOS-kompatiblen Materialien gefertigt sind.

6. Sensor (40) mit einer Anordnung von einer Mehrzahl von Pixeln, wobei mindestens einer der Pixel ein Sensorelement (10, 10') nach einem der vorhergehenden Ansprüche umfasst.

7. Sensor (40) nach Anspruch 6, wobei die Anordnung eine Matrixanordnung (44) einer Mehrzahl von Sensorelementen (10, 10') umfasst.

8. Sensor (40) nach Anspruch 6 oder 7, vorgesehen zur niederohmigen Anbindung an eine Ausleseelektronik (42).

9. Verwendung eines Sensorelements (10) nach einem der vorhergehenden Ansprüche 1 bis 5 in einem Drucksensor, einem Kraftsensor, einem Drehbeschleunigungssensor oder einem Stressensor.

10. Verfahren zum Betreiben eines Sensorelements (10) nach einem der Ansprüche 1 bis 5, wobei ein Auslesen des Sensorelements (10) mittels einer Wechselspannung erfolgt.

11. Verfahren zum Betreiben eines Sensors nach einem der Ansprüche 6 bis 8, wobei ein Auslesen des Sensors (40) zeilen- und/oder spaltenweise erfolgt.

12. Verfahren nach Anspruch 11, wobei ein zeitversetztes Auslesen von Pixeln erfolgt.

**Claims**

1. Sensor element (10) comprising at least one piezoelectric transducer (11), wherein the piezoelectric transducer (11) is coupled to at least one memristor (20), **characterized in that** the memristor (20) is part of a half-bridge.

2. Sensor element (10) according to Claim 1, wherein the piezoelectric transducer (11) is connected in parallel with the half-bridge.

3. Sensor element (10) according to Claim 1, wherein the half-bridge comprises two memristors (20) of opposite polarity.

4. Sensor element (10) according to any of the preceding claims, wherein the sensor element (10) is designed to be operated in read-mode operation (30) or measurement operation (32).

5. Sensor element (10) according to any of the preceding claims, wherein the transducer (11) and the memristor (20) are produced from CMOS-compatible materials.

6. Sensor (40) comprising an arrangement of a plurality of pixels, wherein at least one of the pixels comprises a sensor element (10, 10') according to any of the preceding claims.

7. Sensor (40) according to Claim 6, wherein the arrangement comprises a matrix arrangement (44) of a plurality of sensor elements (10, 10').

8. Sensor (40) according to Claim 6 or 7, provided for low-impedance linking to read-out electronics (42).

9. Use of a sensor element (10) according to any of the preceding Claims 1 to 5 in a pressure sensor, a force sensor, an angular acceleration sensor or a stress sensor.

10. Method for operating a sensor element (10) according to any of Claims 1 to 5, wherein a read-out of the sensor element (10) is effected by means of an AC voltage.

11. Method for operating a sensor according to any of Claims 6 to 8, wherein a read-out of the sensor (40) is effected line by line and/or column by column.

12. Method according to Claim 11, wherein a time-offset read-out of pixels is effected.

**Revendications**

1. Élément capteur (10) comprenant au moins un convertisseur piézoélectrique (11), le convertisseur piézoélectrique (11) étant couplé à au moins une memristance (20), **caractérisé en ce que** la memristance (20) fait partie d'un demi-pont.

2. Élément capteur (10) selon la revendication 1, le convertisseur piézoélectrique (11) étant branché en parallèle avec le demi-pont.

3. Élément capteur (10) selon la revendication 1, le demi-pont comprenant deux memristances (20) de polarités opposées.

4. Élément capteur (10) selon l'une des revendications précédentes, l'élément capteur (10) étant configuré pour fonctionner dans un mode de relevé (30) ou dans un mode de mesure (32).

5. Élément capteur (10) selon l'une des revendications précédentes, le convertisseur (11) et la memristance (20) étant fabriqués dans des matériaux compatibles CMOS.

6. Capteur (40) comprenant un arrangement d'une pluralité de pixels, au moins l'un des pixels comprenant un élément capteur (10, 10') selon l'une des revendications précédentes.

7. Capteur (40) selon la revendication 6, l'arrangement comprenant un arrangement matriciel (44) d'une pluralité d'éléments capteurs (10, 10').

8. Capteur (40) selon la revendication 6 ou 7, conçu pour la connexion à basse impédance à une électronique de relevé (42).

9. Utilisation d'un élément capteur (10) selon l'une des revendications précédentes 1 à 5 dans un capteur de pression, un capteur de force, un capteur d'accélération de rotation ou un capteur de contrainte.

10. Procédé pour faire fonctionner un élément capteur (10) selon l'une des revendications 1 à 5, un relevé de l'élément capteur (10) étant effectué au moyen d'une tension alternative.

11. Procédé pour faire fonctionner un capteur selon l'une des revendications 6 à 8, un relevé du capteur (40) étant effectué ligne par ligne et/ou colonne par colonne.

12. Procédé selon la revendication 11, un relevé décalé dans le temps des pixels étant effectué.

**Fig. 1**

**Fig. 2**

# Fig. 3

# Fig. 4

# Fig. 5

10

14    24    30    31    20

i(t)

C

M    ∿    28

12    11    16    31    22    V    26

# Fig. 6

10

14    32    24    20    22

i(t)

C

M    ∿    28

12    11    16    31    V    26

32

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2109388 A
- EP 1553697 A1
- US 2010019656 A1
- DE 102009026189 A1

**In der Beschreibung aufgeführte Nicht-Patentliteratur**

- **STRUKOV et al.** The missing memristor found. *Nature,* 2008, vol. 453, 80ff